# EUROPÄISCHE PATENTSCHRIFT

(11) **EP 1 573 820 B1**
(45) Veröffentlichungstag und Bekanntmachung des Hinweises auf die Patenterteilung: **14.02.2007**
(21) Anmeldenummer: 03789328.6
(22) Anmeldetag: 18.12.2003
(51) Int. Cl.: H01L 27/115, H01L 21/28, H01L 21/336

(54) **FIN-FELDEFFEKTTRANSISTOR-SPEICHERZELLE, FIN-FELDEFFEKTTRANSISTOR-SPEICHERZELLEN-ANORDNUNG UND VERFAHREN ZUM HERSTELLEN EINER FIN-FELDEFFEKTTRANSISTOR-SPEICHERZELLE**
FIN FIELD EFFECT TRANSISTOR MEMORY CELL, FIN FIELD EFFECT TRANSISTOR MEMORY CELL ARRANGEMENT, AND METHOD FOR THE PRODUCTION OF A FIN FIELD EFFECT TRANSISTOR MEMORY CELL
CELLULE MEMOIRE A TRANSISTOR A EFFET DE CHAMP A AILERON DE SEMI-CONDUCTEUR, DISPOSITIF A CELLULES MEMOIRE A TRANSISTOR A EFFET DE CHAMP A AILERON DE SEMI-CONDUCTEUR, ET PROCEDE POUR REALISER UNE CELLULE MEMOIRE A TRANSISTOR A EFFET DE CHAMP A AILERON DE SEMI-CONDUCTEUR

(30) Priorität: 20.12.2002 DE 10260334
(43) Veröffentlichungstag der Anmeldung: 14.09.2005
(73) Patentinhaber: Qimonda AG, 81739 München (DE)
(72) Erfinder: DREESKORNFELD, Lars, 85579 Neubiberg (DE); HARTWICH, Jessica, 85579 Neubiberg (DE); HOFMANN, Franz, 80995 München (DE); KRETZ, Johannes, 80538 München (DE); SPECHT, Michael, 80799 München (DE)
(74) Vertreter: Viering, Jentschura & Partner
(86) Internationale Anmeldenummer: PCT/EP2003/014473
(87) Internationale Veröffentlichungsnummer: WO 2004/059738

(56) Entgegenhaltungen:
- DE-A- 19 823 733
- US-B1- 6 288 431
- US-B1- 6 413 802

## Beschreibung

Die Erfindung betrifft eine Fin-Feldeffekttransistor-Speicherzelle, eine Fin-Feldeffekttransistor-Speicherzellen-Anordnung und ein Verfahren zum Herstellen einer Fin-Feldeffekttransistor-Speicherzelle.

Angesichts der schnellen Entwicklung in der Computertechnologie besteht Bedarf an hochdichten, leistungsarmen und nichtflüchtigen Speichern, insbesondere für mobile Anwendungen im Bereich der Datenspeicherung.

Aus dem Stand der Technik ist ein Floating-Gate-Speicher bekannt, bei dem oberhalb einer Gate-isolierenden Schicht eines in einem Substrat integrierten Feldeffekttransistors ein elektrisch leitfähiger Floating-Gate-Bereich angeordnet ist, in welchen mittels Fowler-Nordheim-Tunnelns elektrische Ladungsträger dauerhaft eingebracht werden können. Aufgrund des Feldeffekts ist der Wert der Schwellenspannung eines solchen Transistors davon abhängig, ob in dem Floating-Gate Ladungsträger gespeichert sind oder nicht. Somit ist in dem Vorhandensein bzw. Nichtvorhandensein elektrischer Ladungsträger in der Floating-Gate-Schicht eine Speicherinformation kodierbar.

Allerdings ist zum Einbringen von elektrischen Ladungsträgern in ein Floating-Gate eine hohe Spannung von typischerweise 15V bis 20V erforderlich. Dies kann zu einer Schädigung empfindlicher integrierter Bauelemente führen und ist zudem für energiesparende (z.B. Low-Power-Anwendungen) oder mobile Anwendungen (z.B. Mobilfunktelefone, Personal Digital Assistant, PDA) unattraktiv. Ferner liegen die Schreibzeiten bei Fowler-Nordheim Tunneln typischerweise im Bereich von Millisekunden und sind somit zu lang, um den Anforderungen moderner Speicher gerecht zu werden.

Bei einem NROM-Speicher ("nitrided read only memory") wird eine Siliziumnitrid-Trappingschicht als Gate-isolierende Schicht eines Feldeffekttransistors verwendet, wobei mittels Channel Hot Electron Injection Ladungsträger dauerhaft in die Siliziumnitrid-Schicht als Ladungsspeicherschicht eingebracht werden können. Typische Programmierspannungen liegen in diesem Fall bei ungefähr 9V, und es sind Schreibzeiten von 150ns an einer Einzelzelle erreicht.

Aus [1] ist eine NROM-Speicherzelle bekannt, bei der in einem Transistor zwei Bit Speicherinformation gespeichert werden können.

Eine NROM-Speicherzelle weist jedoch den Nachteil einer hohen Leistungsaufnahme auf. Ferner ist die Skalierbarkeit von NROM-Speicherzellen aufgrund von Kurzkanaleffekten, wie dem "punch through" Effekt, die insbesondere bei einer Kanallänge von typischerweise unter 200nm auftritt, schlecht. Darüber hinaus ist bei einer geringen Weite von Transistoren von NROM-Speicherzellen der Lesestrom sehr klein. Auch dies steht einer fortgesetzten Skalierung entgegen.

Aus [2] ist eine MONOS-Speicherzelle bekannt, bei der ein Steuer-Gate separat von einer Wortleitung vorgesehen ist. Das Speichern von Information erfolgt gemäß [2] mittels sourceseitigen Injizierens von Ladungsträgern in eine ONO-Ladungsspeicherschicht (Siliziumoxid-Siliziumnitrid-Siliziumoxid). Hierdurch ist die Leistungsaufnahme gegenüber einer herkömmlichen NROM-Speicherzelle erniedrigt.

Druckschrift us6288431 beschreibt ein EPPROM-Bauelement mit einer Gate-Elektrode,aufweisend ein Floating-Gate, eine Isolationsschicht auf dem Floating-Gate und ein steuer-Gate, das auf der Isolationsschicht angeordnet ist. Die Gate-Elektrode befindet sich auf einer quaderförmigen Erhebung und ist gegen diese durch eine Gate-oxid schicht isoliert.

Jedoch weist auch die aus [2] bekannte Speicherzelle das Problem einer schlechten Skalierbarkeit und eines geringen Lesestroms insbesondere bei einer kleinen Transistorweite auf.

Zusammenfassend weist eine Floating-Gate-Speicherzelle den Nachteil einer hohen Spannung und eines nicht ausreichend schnellen seriellen Zugriffs auf die einzelne Speicherzelle auf. Eine Splitgate-Zelle hat den Nachteil einer schlechten Skalierbarkeit und einer mäßigen Speicherdichte pro Bit. Nachteile der aus [2] bekannten, auf source-seitigem Injizieren von Ladungsträgern basierenden Speicherzelle ist die schlechte Skalierbarkeit unterhalb von 200nm Kanallänge und ein geringer Lesestrom bei einer kleinen Transistorweite.

Der Erfindung liegt insbesondere das Problem zugrunde, eine Speicherzelle, eine Speicherzellen-Anordnung und ein Verfahren zum Herstellen einer Speicherzelle anzugeben, bei denen eine leistungsarme Programmierung, eine hohe Speicherdichte und eine gute Skalierbarkeit realisiert sind.

Das Problem wird durch eine Fin-Feldeffekttransistor-Speicherzelle, durch eine Fin-Feldeffekttransistor-Speicherzellen-Anordnung und durch ein Verfahren zum Herstellen einer Fin-Feldeffekttransistor-Speicherzelle mit den Merkmalen gemäß den unabhängigen Patentansprüchen gelöst.

Die erfindungsgemäße Fin-Feldeffekttransistor-Speicherzelle enthält einen ersten und einen zweiten Source-/Drain-Bereich, einen Gate-Bereich und eine den Kanal-Bereich aufweisende Halbleiter-Finne zwischen dem ersten und dem zweiten Source-/Drain-Bereich. Die Fin-Feldeffekttransistor-Speicherzelle enthält ferner eine Ladungsspeicherschicht, die zumindest teilweise auf dem Gate-Bereich angeordnet ist, und einen Wortleitungsbereich auf zumindest einem Teil der Ladungsspeicherschicht. Die Ladungsspeicherschicht ist derart eingerichtet, dass mittels Anlegens vorgebbarer elektrischer Potentiale an die Fin-Feldeffekttransistor-Speicherzelle in die Ladungsspeicherschicht elektrische Ladungsträger selektiv einbringbar oder daraus entfernbar sind.

Darüber hinaus ist erfindungsgemäß eine Fin-Feldeffekttransistor-Speicherzellen-Anordnung mit einer Mehrzahl von Fin-Feldeffekttransistor-Speicherzellen mit den oben genannten Merkmalen geschaffen.

Ferner ist ein Verfahren zum Herstellen einer Fin-Feldeffekttransistor-Speicherzelle bereitgestellt, bei dem ein erster und ein zweiter Source-/Drain-Bereich ausgebildet werden, ein Gate-Bereich gebildet wird und eine einen Kanal-Bereich aufweisende Halbleiter-Finne zwischen dem ersten und dem zweiten Source-/Drain-Bereich gebildet wird. Ferner wird eine Ladungsspeicherschicht gebildet, die zumindest teilweise auf dem Gate-Bereich angeordnet wird. Ein Wortleitungsbereich wird auf zumindest einem Teil der Ladungsspeicherschicht gebildet. Die Ladungsspeicherschicht wird derart eingerichtet, dass mittels Anlegens vorgebbarer elektrischer Potentiale an die Fin-Feldeffekttransistor-Speicherzelle in die Ladungsspeicherschicht elektrische Ladungsträger selektiv einbringbar oder daraus entfernbar sind.

Eine Grundidee der Erfindung ist darin zu sehen, dass eine Speicherzelle auf Basis eines Fin-Feldeffekttransistors (im Weiteren auch als Fin-FET bezeichnet) geschaffen wird, bei welcher eine Ladungsspeicherschicht zwischen einem Gate-Bereich und einem auf diesem ausgebildeten Wortleitungsbereich angeordnet wird. Bei einer solchen Fin-FET-Anordnung können beispielsweise an einer oder mehreren Seitenflächen das Gate-Bereichs angeordnete Ladungsspeicherschicht-Bereiche unter Verwendung einer sourceseitigen (bzw. drainseitigen) Injektion leistungsarm programmiert werden. Die Ladungsspeicherschicht kann beispielsweise als ONO-Schichtenfolge (Siliziumoxid-Siliziumnitrid-Siliziumoxid) realisiert sein. In einer solchen Ladungsspeicherschicht können dauerhaft elektrische Ladungsträger gespeichert werden, welche die Leitfähigkeit eines mittels einer Halbleiter-Finne realisierten Kanal-Bereichs signifikant beeinflussen, worin die Speicherinformation kodiert werden kann.

Bei der erfindungsgemäßen Anordnung ist abgesehen von dem Gate-Bereich ein davon in der Regel elektrisch entkoppelter Wortleitungsbereich gebildet, wobei die Anordnung als Splitgate-Anordnung bezeichnet werden kann. Mit der erfindungsgemäßen Speicherzelle ist ein leistungsärmeres Programmieren ermöglicht.

Ferner weist die erfindungsgemäße Speicherzelle eine hohe Speicherdichte von zwei Bit auf. Ein erstes Bit kann in der Ladungsspeicherschicht in einem Grenzbereich zwischen dem ersten Source-/Drain-Bereich und dem Wortleitungsbereich in Form von dort eingebrachten Ladungsträgern gespeichert sein. Ein zweites Bit kann in der Ladungsspeicherschicht in einem Grenzbereich zwischen dem zweiten Source-/Drain-Bereich und dem Wortleitungsbereich in Form von dort eingebrachten Ladungsträgern gespeichert sein. Somit ist eine hohe Speicherdichte und ein geringer Kostenaufwand pro Bit ermöglicht.

Mit der Erfindung ist eine Speicherzelle bereitgestellt, die aufgrund der Doppelgate-Wirkung eines Fin-Feldeffekttransistors eine bessere Skalierbarkeit der Kanallänge ermöglicht als bei einer rein planaren Geometrie wie beispielsweise in [1]. Die erfindungsgemäße Speicherzelle weist eine hohe Speicherdichte von typischerweise 2F² bis 4F² auf, wobei F die bei einer Technologiegeneration minimal erreichbare Strukturdimension ist.

Ferner kann bei dem Designen und Herstellen der erfindungsgemäßen Fin-Feldeffekttransistor-Speicherzelle die Höhe der Finne aus halbleitendem Material derart eingestellt werden, dass ein gewünschter Lesestrom erreichbar ist. Die Höhe der Finne ist somit ein Freiheitsgrad beim Gestalten der Speicherzelle, mit welchem die Lese- und Programmier-Eigenschaften einstellbar sind.

Somit besteht ein wichtiger Aspekt der Erfindung darin, in einer Fin-FET-Speicherzellen-Anordnung ein leistungsarmes Programmieren mittels sourceseitigen Injizierens von Ladungsträgern zu vereinen mit einer hohen Speicherdichte, mit einem hohen Lesestrom, geringen Kosten pro Bit und einer besseren Skalierbarkeit als bei einer NROM-Speicherzelle oder einer Floating-Gate-Speicherzelle.

Die erfindungsgemäße Fin-Feldeffekttransistor-Speicherzelle kombiniert die Vorteile des "sourceside-injection"-Programmierens mit den Vorteilen einer Doppelgate-Anordnung unter Verwendung eines Fin-FETs und ist somit besser skalierbar. Ferner ist ein weiterer Vorteil in der Kompatibilität der Speicherzelle zu Logikbauelementen mit Fin-FET-Geometrie zu sehen.

Bevorzugte Weiterbildungen der Erfindung ergeben sich aus den abhängigen Ansprüchen.

Bei der erfindungsgemäßen Speicherzelle kann der Wortleitungsbereich in einen ersten Wortleitungsteilbereich und in einen zweiten Wortleitungsteilbereich derart aufgeteilt sein, dass in einen Grenzbereich des ersten Wortleitungsteilbereichs mit der Ladungsspeicherschicht und in einen Grenzbereich des zweiten Wortleitungsteilbereichs mit der Ladungsspeicherschicht jeweils elektrische Ladungsträger einbringbar sind oder daraus entfernbar sind. Das Aufteilen des Wortleitungsbereichs in zwei (entweder elektrisch voneinander entkoppelte oder miteinander gekoppelte) Wortleitungsteilbereiche kann derart realisiert sein, dass zwei zueinander entlang den Seitenflächen der Fin-FET-Transistoren im Wesentlichen parallel verlaufende Wortleitungen geschaffen sind.

Die ersten und zweiten Wortleitungsteilbereiche können an zwei gegenüberliegenden seitlichen Abschnitten des Gate-Bereichs (Steuer-Gate-Bereich) angeordnet sein.

Die Ladungsspeicherschicht kann eine Siliziumoxid-Siliziumnitrid-Siliziumoxid-Schichtenfolge (ONO-Schichtenfolge), Aluminiumoxid (Al₂O₃), Yttriumoxid (Y₂O₃), Lanthanoxid (LaO₂) Hafniumoxid (HfO₂), Zirkoniumoxid (ZrO₂), amorphes Silizium, Tantaloxid (Ta₂O₅), Titanoxid (TiO₂) und/oder ein Aluminat aufweisen oder daraus bestehen. Ein Beispiel für ein Aluminat ist eine Legierung aus den Komponenten Aluminium, Zirkonium und Sauerstoff (AlZrO). Eine als ONO-Schichtenfolge realisierte Ladungsspeicherschicht weist drei Teilschichten auf, die jeweils eine Dicke von 5nm aufweisen können.

Insbesondere kann die Ladungsspeicherschicht anschaulich in DRAM-tauglicher Weise ("Dynamic Random Access Memory") dimensioniert bzw. eingerichtet sein, d.h. es können Programmierzeiten von 10ns und weniger erreicht werden. Hierfür sind die Teilschichten der Ladungsspeicherschicht ausreichend dünn vorzusehen. Beispielsweise kann in diesem Fall die Ladungsspeicherschicht aus einem Tunneldielektrikum, einem Speicherdielektrikum und einem Blocking-Dielektrikum gebildet sein. Das Tunneldielektrikum kann eine Dicke von typischerweise 1nm bis 3nm aufweisen und kann zum Beispiel aus Siliziumoxid gebildet sein. Das Speicherdielektrikum kann eine Dicke von typischerweise 2nm bis 4nm aufweisen und kann zum Beispiel aus amorphem Silizium oder aus einem High-k-Material mit ausreichend niedriger Barrierenhöhe _(z.B. Ta₂O₅ oder TiO₂) gebildet sein. Das Blockingdielektrikum kann eine Dicke von typischerweise 2nm aufweisen und kann zum Beispiel aus Siliziumoxid oder einem High-k-Material gebildet sein.

Für eine ausreichend kurze Schreibzeit von 10ns ist somit eine ausreichend dünne Ladungsspeicherschicht (bzw. sind ausreichend dünne Teilschichten der Ladungsspeicherschicht) zu verwenden. Wird eine besonders hohe Haltezeit (typisch zehn Jahre) angestrebt, so ist die Ladungsspeicherschicht ausreichend dick vorzusehen.

Der Gate-Bereich der Speicherzelle kann die Halbleiter-Finne im Wesentlichen U-förmig umgeben. Mit dieser Konfiguration ist ein Doppelgate geschaffen, mit dem eine besonders exakte Steuerung der Leitfähigkeit des Kanal-Bereichs der Speicherzelle ermöglicht ist.

Die Höhe der Halbleiter-Finne wird vorzugsweise derart eingestellt, dass ein vorgebbarer Wert für einen Lesestrom zum Auslesen von in der zugehörigen Speicherzelle gespeicherter Information erreicht wird.

Die Speicherzelle kann einen mit dem ersten Source-/Drain-Bereich gekoppelten ersten Bitleitungsbereich und einen mit dem zweiten Source-/Drain-Bereich gekoppelten zweiten Bitleitungsbereich aufweisen.

Die Source-/Drain-Bereiche können dotierte Abschnitte der Halbleiter-Finne sein oder können als Teil der Bitleitungsbereiche realisiert sein.

Ferner kann die Speicherzelle derart eingerichtet sein, dass mittels Anlegens vorgebbarer elektrischer Potentiale an den Gate-Bereich, an den Wortleitungsbereich und/oder an zumindest einen Bitleitungsbereich Ladungsträger in die Ladungsspeicherschicht mittels Injizierens heißer Ladungsträger selektiv einbringbar oder daraus entfernbar sind.

Im Weiteren wird die erfindungsgemäße Fin-Feldeffekttransistor-Speicherzellen-Anordnung, die erfindungsgemäße Fin-Feldeffekttransistor-Speicherzellen aufweist, näher beschrieben. Ausgestaltungen der Speicherzelle gelten auch für die Speicherzellen-Anordnung.

Die Fin-Feldeffekttransistor-Speicherzellen der Speicherzellen-Anordnung können im Wesentlichen matrixförmig angeordnet sein.

Die Speicherzellen-Anordnung kann für entlang einer ersten Richtung angeordnete Speicherzellen einen gemeinsamen Wortleitungsbereich aufweisen. Zum Beispiel kann eine Zeile oder Spalte von Speicherzellen eine oder mehrere gemeinsame Wortleitungen aufweisen.

Ferner kann die Speicherzellen-Anordnung für entlang einer zweiten Richtung angeordnete Speicherzellen gemeinsame Bitleitungsbereiche aufweisen. Zum Beispiel können eine Spalte oder Zeile von Speicherzellen eine oder mehrere gemeinsame Bitleitungen aufweisen.

Die erste und die zweite Richtung sind zueinander vorzugsweise im Wesentlichen orthogonal orientiert.

Bei der Speicherzellen-Anordnung kann die laterale Ausdehnung eines Wortleitungsbereichs in einem Abschnitt, in dem er einen Gate-Bereich kreuzt, anders (insbesondere kleiner) sein als in einem von einer Kreuzung mit einem Gate-Bereich freien Abschnitt.

Ausführungsbeispiele der Erfindung sind in den Figuren dargestellt und werden im Weiteren näher erläutert.

Es zeigen:
- Figur 1: eine schematische Anordnung, anhand welcher das Prinzip des sourceseitiges Programmierens beschrieben wird,
- Figur 2: eine perspektivische Ansicht einer Fin-Feldeffekttransistor-Speicherzelle gemäß einem bevorzugten Ausführungsbeispiel der Erfindung,
- Figur 3: eine Layout-Ansicht einer Fin-Feldeffekttransistor-Speicherzellen-Anordnung gemäß einem bevorzugten Ausführungsbeispiel der Erfindung,
- Figur 4: eine erste Querschnittsansicht der in Figur 3 gezeigten Speicherzellen-Anordnung, aufgenommen entlang einer Schnittlinie I-I' aus Figur 3,
- Figur 5: eine zweite Querschnittansicht der in Figur 3 gezeigten Speicherzellen-Anordnung; aufgenommen entlang einer Schnittlinie II-II' aus Figur 3,
- Figuren 6A bis 6F: Querschnittansichten von Schichtenfolgen zu unterschiedlichen Zeitpunkten während eines Verfahrens zum Herstellen einer Fin-Feldeffekttransistor-Speicherzellen-Anordnung gemäß einem bevorzugten Ausführungsbeispiel der Erfindung.

Gleiche oder ähnliche Komponenten in unterschiedlichen Figuren sind mit gleichen Bezugsziffern versehen.

Die Darstellungen in den Figuren sind schematisch und nicht maßstäblich.

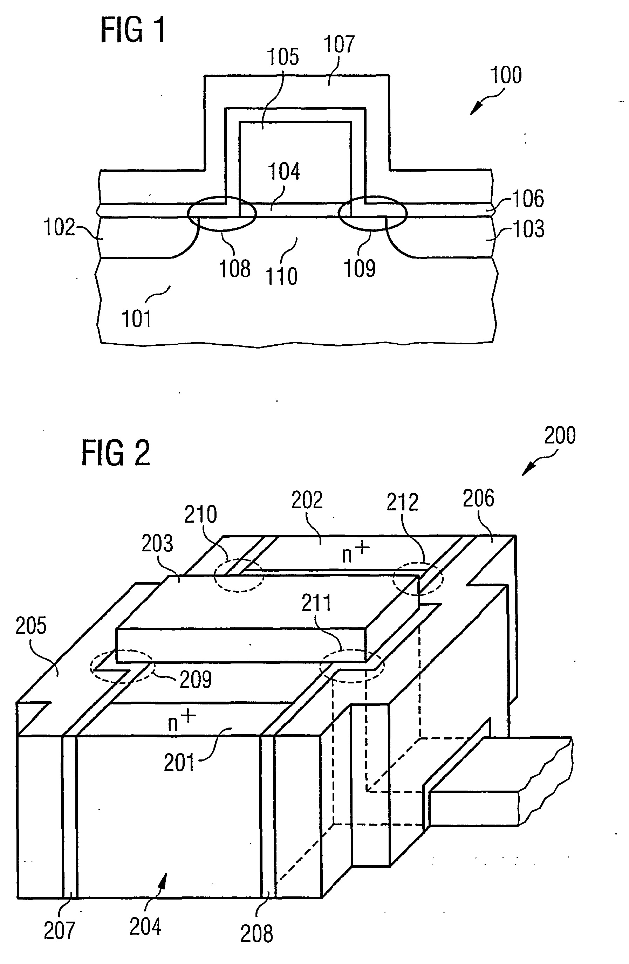

Im Weiteren wird bezugnehmend auf **Fig.1** das sourceseitige (bzw. drainseitige) Injizieren von Ladungsträgern mit einem in ein Steuer-Gate und in eine von diesem elektrisch entkoppelte Wortleitung aufgeteilten Gate beschrieben. Mit dem im Weiteren beschriebenen Programmierschema ist die erfindungsgemäße Speicherzelle programmierbar bzw. auslesbar.

In Fig.1 ist eine Speicherzelle 100 gezeigt, die auf und in einem Silizium-Substrat 101 ausgebildet ist. Auf dem Silizium-Substrat 101 zwischen einer ersten und einer zweiten Bitleitung 102, 103 ist ein Gate-Dielektrikum 104 vorgesehen. Auf dem Gate-Dielektrikum 104 ist ein Steuer-Gate 105 angeordnet. Auf dieser Schichtenfolge ist eine ONO-Schichtenfolge 106 als Ladungsspeicherschicht ausgebildet. Auf der ONO-Schichtenfolge 106 ist eine Wortleitung 107 ausgebildet, welche sich bis über die Bitleitungen 102, 103 hinweg erstreckt und mittels der ONO-Schichtenfolge 106 von den Bitleitungen 102, 103 elektrisch entkoppelt ist. Ferner sind in Fig.1 ein erster Ladungsspeicherbereich 108 der Ladungsspeicherschicht 106 in einem Grenzbereich zwischen erster Bitleitung 102, Steuer-Gate 105 und Wortleitung 107 gezeigt, und es ist ein zweiter Ladungsspeicherbereich 109 der Ladungsspeicherschicht 106 in einem Grenzbereich zwischen zweiter Bitleitung 103, Steuer-Gate 105 und Wortleitung 107 gezeigt.

Im Weiteren wird beschrieben, welche elektrischen Potentiale an die Anschlüsse der Speicherzelle 100 angelegt werden, um in die Ladungsspeicherbereiche 108, 109 elektrische Ladungsträger einzubringen und somit eine Speicherinformation zu programmieren.

Um in den ersten Ladungsspeicherbereich 108 elektrische Ladungsträger einzubringen, wird die Wortleitung 107 auf ein elektrisches Potential von beispielsweise 9V gebracht. Die erste Bitleitung 102 wird auf ein Potential von beispielsweise 5V gebracht, wohingegen die zweite Bitleitung 103 auf eine elektrisches Potential von 0V gebracht wird. Zum Ermöglichen eines "sourceseitigen" Injizierens heißer Elektronen ("source-side hot-electron injection", SSHE) wird das Steuer-Gate 500 auf ein Potential von ungefähr 1V (nahe der Schwellenspannung der Feldeffekttransistor-ähnlichen Anordnung 100) gebracht. Um das Injizieren von Ladungsträgern zu unterdrücken, wird das Steuer-Gate 105 dagegen auf ein elektrisches Potential von 0V gebracht. Auf diese Weise können in den ersten Ladungsspeicherbereich 108 dauerhaft elektrische Ladungsträger eingebracht werden. Um in den zweiten Ladungsspeicherbereich 109 Ladungsträger einzubringen, können die elektrischen Potentiale der Bitleitungen 102, 103 einfach vertauscht werden. Es ist anzumerken, dass die Ladungsspeicherbereiche 108, 109 rein schematisch zum Zweck einer anschaulichen Erklärung in die Figur eingefügt sind. Tatsächlich können diese Bereiche stärker oder schwächer räumlich ausgedehnt sein als in der Figur gezeigt oder können an einer etwas anderen Stelle in der Ladungsspeicherschicht lokalisiert sein.

Zum Auslesen von in den Ladungspeicherbereichen 108 bzw. 109 enthaltener Information wird das Steuer-Gate 105 auf ein elektrisches Potential von ungefähr 1.5V gebracht und zwischen die Bitleitungen 102, 103 eine Spannung von 1.5V angelegt. Die Wortleitung 107 kann in diesem Betriebszustand auf ein elektrisches Potential von ungefähr 1.5V bis 3V gebracht sein, zum Erzielen von Inversion. Der Wert des durch den Kanal-Bereich 110 fließenden elektrischen Stroms hängt dann davon ab, ob in dem ersten Ladungsspeicherbereich 108 und/oder in dem zweiten Ladungsspeicherbereich 109 elektrische Ladungsträger enthalten sind oder nicht, da anschaulich in einen der Ladungsspeicherbereiche 108, 109 eingebrachte Ladungsträger einen ähnlichen Einfluss auf die elektrische Leitfähigkeit des Kanal-Bereichs 110 haben wie eine an das Steuer-Gate 105 angelegte Spannung. In dem Wert des ermittelten elektrischen Stroms ist die gespeicherte Speicherinformation kodiert.

Zum Löschen von Information aus einem der Ladungsspeicherbereiche 108, 109 der Speicherzelle 100 wird das Steuer-Gate 105 auf ein elektrisches Potential von beispielsweise 5V gebracht. Um Information aus dem ersten Ladungsspeicherbereich 108 zu löschen, wird die erste Bitleitung 102 auf ein elektrisches Potential von beispielsweise 0V gebracht, wohingegen die zweite Bitleitung 103 auf ein elektrisches Potential von 7V gebracht wird. Zum Löschen der Information in dem zweiten Ladungsspeicherbereich 109 können die Potentiale an den Bitleitungen 102, 103 einfach ausgetauscht werden.

Im Weiteren wird bezugnehmend auf Fig.2 eine Fin-Feldeffekttransistor-Speicherzelle 200 gemäß einem bevorzugten Ausführungsbeispiel der Erfindung beschrieben.

Die Fin-FET-Speicherzelle 200 weist einen ersten Source-/Drain-Bereich 201 und einen zweiten Source-/Drain-Bereich 202 auf. Zwischen den beiden Source-/Drain-Bereichen 201, 202 ist ein Kanal-Bereich angeordnet, wobei der Kanal-Bereich und die beiden Source-/Drain-Bereiche 202, 201 Komponenten einer Silizium-Finne 204 sind. Die beiden Source-/Drain-Bereiche 201, 202 sind als zwei mittels des Kanal-Bereichs voneinander getrennte Bereiche der Silizium-Finne 204 realisiert, wobei die Source-/Drain-Bereiche mittels Implantierens von n⁺-Dotieratomen (beispielsweise Arsen) in Bereiche der Silizium-Finne 204 gebildet sind. Auf dem Kanal-Bereich ist ein Steuer-Gate 204 in U-förmiger Weise ausgebildet, wobei zwischen dem Kanal-Bereich und dem Steuer-Gate 203 eine in Fig.2 nicht gezeigte dünne Gate-isolierende Schicht ausgebildet ist. Ferner ist in Fig.2 ein erster ONO-Bereich 207 (Siliziumoxid-Siliziumnitrid-Siliziumoxid-Schichtenfolge) gebildet, und es ist ein zweiter ONO-Bereich 208 gebildet. Die ONO-Bereiche 207, 208 sind auf gegenüberliegenden Seitenflächen der Silizium-Finne 204 bzw. des Steuer-Gates 203 gebildet. Die ONO-Bereiche 207, 208 sind derart eingerichtet, dass in sie mittels Anlegens vorgebbarer elektrischer Potentiale an die Anschlüsse der Fin-FET-Speicherzelle 200 elektrische Ladungsträger selektiv einbringbar oder daraus entfernbar sind, wobei in möglicherweise in einen oder beide ONO-Bereiche 207, 208 eingebrachten Ladungsträgern eine Speicherinformation kodiert ist. Ferner ist eine erste Wortleitung 205 seitlich auf dem ersten ONO-Bereich 207 aufgebracht. Ferner ist eine zweite Wortleitung 206 seitlich auf dem zweiten ONO-Bereich 208 aufgebracht.

In Fig.2 sind schematisch erste bis vierte Ladungsspeicher-Bereiche 209 bis 212 gezeigt, welche Teilbereiche der ersten bzw. zweiten ONO-Bereiche 207, 208 sind, und in welche Ladungsspeicher-Bereiche 209 bis 212 elektrische Ladungsträger mittels sourceseitigen (bzw. drainseitigen) Injizierens von Ladungsträgern oder Löchern einbringbar sind (vgl. Fig.1 und zugehörige Beschreibung).

Um beispielweise in dem ersten Ladungsspeicherbereich 209 elektrische Ladungsträger einzubringen, wird die erste Wortleitung 205 auf ein elektrisches Potential von 9V gebracht, wohingegen eine an den ersten Source-/Drain-Bereich 201 angrenzende erste Bitleitung auf ein Potential von 5V gebracht wird. Eine an den zweiten Source-/Drain-Bereich 202 angrenzende zweite Bitleitung wird auf ein Potential von 0V gebracht. Um ein Einbringen von elektrischen Ladungsträgern in den ersten Ladungsspeicherbereich 209 zu ermöglichen, wird das Steuer-Gate 203 auf ein Potential von 1V gebracht. Bei einem Potential von 0V an dem Steuer-Gate 203 ist dagegen ein Einbringen von elektrischen Ladungsträgern in den ersten Ladungsspeicherbereich 209 vermieden. Auf entsprechende Weise können in jeden der Ladungsspeicherbereiche 209 bis 212 Ladungsträger eingebracht werden, wodurch in Ladungsspeicherbereichen 209 bis 212 Speicherinformation programmierbar ist. Diese Information ist auslesbar, indem zwischen die Source-/Drain-Bereiche 201, 202 eine vorgegebene elektrische Spannung von beispielsweise 1.5V angelegt wird und ferner das Steuer-Gate 203 auf ein vorgegebenes elektrisches Potential von beispielsweise 1.5V gebracht wird. Ferner wird zum Auslesen einer Information in dem ersten Ladungsspeicherbereich 209 die erste Wortleitung 205 auf ein elektrisches Potential von ungefähr 1.5V bis 3V gebracht. Aufgrund des Feldeffekts in dem Kanal-Bereich zwischen den Source-/Drain-Bereichen 201, 202 ist der Wert des Stromflusses zwischen den Source-/Drain-Bereichen 201, 202 davon abhängig, ob in den jeweiligen Ladungsspeicherbereichen 209 bis 212 elektrische Ladungsträger eingebracht sind oder nicht. Somit ist in dem Wert des Stromflusses (bzw. in einer charakteristischen Veränderung des Werts der Schwellenspannung der Fin-FET-Anordnung 200) die in den Speicherbereichen 209 bis 212 enthaltene Speicherinformation enthalten.

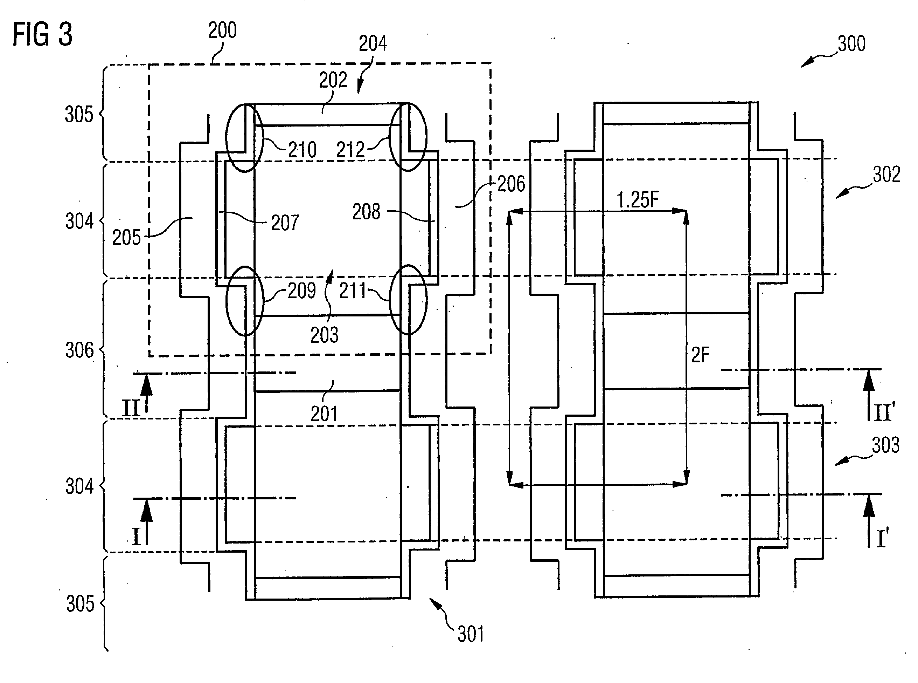

Im Weiteren wird bezugnehmend auf **Fig.3** eine Fin-Feldeffekttransistor-Speicherzellen-Anordnung 300 gemäß einem bevorzugten Ausführungsbeispiel der Erfindung beschrieben.

Fig.3 ist eine Layout-Ansicht. In Fig.3 sind vier Fin-FET-Speicherzellen der in Fig.2 gezeigten Art miteinander zu einer Fin-FET-Speicherzellen-Anordnung 300 verschaltet. Ferner sind in Fig.3 Dimensionsangaben in F angegeben, wobei F die in einer Technologiegeneration minimal erreichbare Strukturdimension ist. Wie in Fig.3 gezeigt ist, sind die Speicherzellen 200, 301 bis 303, matrixförmig angeordnet, wobei für eine jeweilige Spalte von Speicherzellen jeweils eine gemeinsame erste Wortleitung 205 und eine gemeinsame zweite Wortleitung 206 bereitgestellt sind. Ferner sind für eine jeweilige Zeile von Speicherzellen eine gemeinsame Steuer-Gate-Leitung 304 sowie gemeinsame erste und zweite Bitleitung 305, 306 vorgesehen.

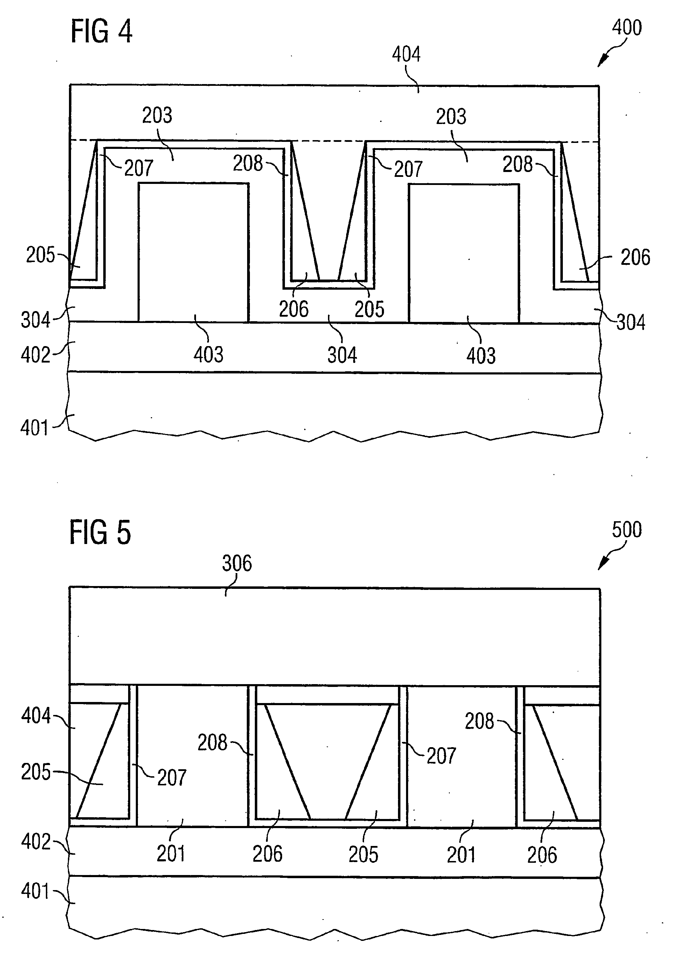

Im Weiteren wird bezugnehmend auf **Fig.4** eine erste Querschnittsansicht 400 des in Fig.3 gezeigten Layouts der Fin-FET-Speicherzellen-Anordnung 300 beschrieben. Die erste Querschnittsansicht 400 ist aufgenommen entlang einer in Fig.3 gezeigten Schnittlinie I-I'.

In der ersten Querschnittsansicht 400 ist gezeigt, dass die Fin-FET-Speicherzellen-Anordnung 300 auf einer Siliziumoxid-Schicht 402 ausgebildet ist, welche wiederum auf einem Silizium-Substrat 401 angeordnet ist. Ferner ist in Fig.4 der Kanal-Bereich 403 der Silizium-Finne 204 gezeigt. Auf der in Fig.4 gezeigten Schichtenfolge ist eine Siliziumnitrid-Schicht 404 aufgebracht, die planarisiert ist. Wie ferner in Fig.4 gezeigt ist, weisen die Wortleitungen 205, 206 gemäß dem beschriebenen Ausführungsbeispiel einen annähernd dreieckförmigen Querschnitt auf. Wie in Fig.4 gezeigt, sind die ONO-Bereiche 207, 208 als zusammenhängende ONO-Schichtenfolge ausgebildet. Da eine ONO-Schichtenfolge elektrisch isolierend ist, sind möglicherweise in ihr eingebrachte elektrische Ladungsträger an einem Bewegen entlang der ONO-Schichtenfolge gehindert, so dass die die Speicherinformation enthaltenden in der ONO-Schichtenfolge eingebrachten elektrischen Ladungsträger vor einem Ausschmieren oder Abfließen geschützt sind.

Im Weiteren wird bezugnehmend auf **Fig.5** eine zweite Querschnittsansicht 500 der Fin-FET-Speicherzellen-Anordnung 300 aus Fig.3 beschrieben, aufgenommen entlang einer in Fig.3 gezeigten Schnittlinie II-II'.

Wie in Fig.5 gezeigt, ist der Querschnitt der ersten und zweiten Wortleitungen 205, 206 entlang der Schnittlinie II-II' ebenfalls im Wesentlichen dreieck- (bzw. leicht trapez-) förmig, allerdings mit einer anderen Querschnittsfläche als bei der ersten Querschnittsansicht 400.

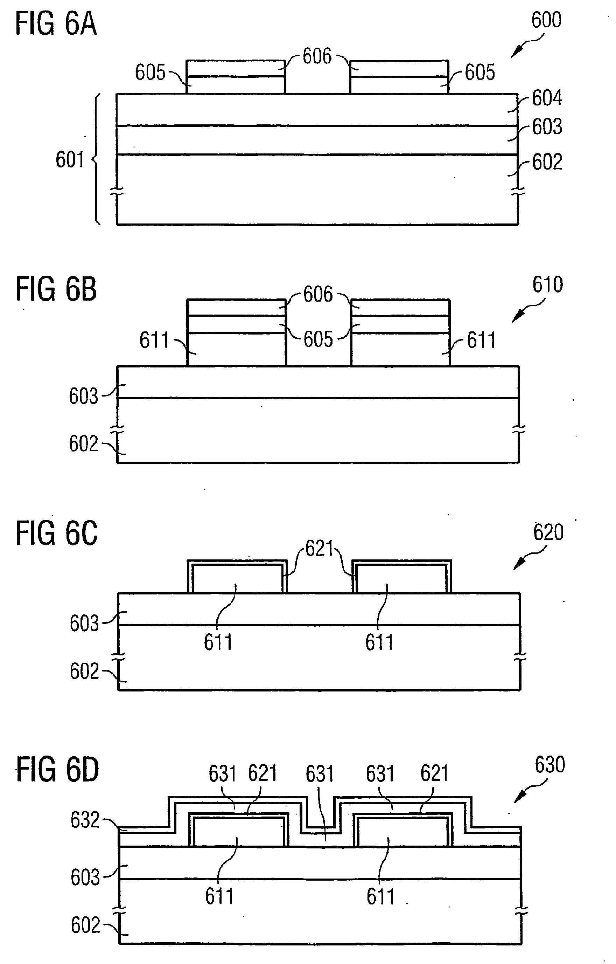

Im Weiteren wird bezugnehmend auf Fig.6A bis Fig.6F ein Verfahren zum Herstellen einer Fin-FET-Speicherzellen-Anordnung gemäß einem bevorzugten Ausführungsbeispiel der Erfindung beschrieben.

Um die in **Fig.6A** gezeigte Schichtenfolge 600 zu erhalten, wird zunächst ein SOI-Wafer 601 bereitgestellt. Dieser ist aus einer ersten Silizium-Schicht 602, einer auf der ersten Silizium-Schicht 602 gebildeten Siliziumoxid-Schicht 603 und aus einer auf der Siliziumoxid-Schicht 603 gebildeten zweiten Silizium-Schicht 604 gebildet. Auf der so erhaltenen Schichtenfolge wird eine TEOS-Hartmaske 605 (Tetra-Ethyl-Ortho-Silicate) ausgebildet. Auf der so erhaltenen Schichtenfolge wird eine Photoresist-Schicht 606 ausgebildet, und gemeinsam mit der TEOS-Schichtenfolge 605 unter Verwendung eines Lithographie- und eines Ätz-Verfahrens derart strukturiert, dass in-einem nachfolgenden Verfahrensschritt aus der zweiten Silizium-Schicht 604 Silizium-Finnen erzeugt werden können.

Um die in **Fig.6B** gezeigte Schichtenfolge 610 zu erhalten, wird die Schichtenfolge 600 einem Ätz-Verfahren unterzogen, wodurch Silizium-Finnen 611 entsprechend der mittels der TEOS-Hartmaske 605 und des Photoresists 606 definierten Maske erhalten werden.

Um die in **Fig.6C** gezeigte Schichtenfolge 620 zu erhalten, werden der Photolack 606 und die TEOS-Hartmaske 605 entfernt. Die so erhaltene Schichtenfolge kann ferner einem Verrundungs-Oxidations-Verfahren bzw. einem Rückätz-Verfahren unterzogen werden. Nachfolgend wird unter Verwendung eines thermischen Oxidier-Verfahrens eine Gate-isolierende Schicht 621 auf freiliegenden Oberflächenbereichen der Silizium-Finnen 611 gebildet, wodurch ein Kanal-Dielektrikum (Gate-isolierende Schicht) für den auszubildenden Fin-FET ausgebildet wird.

Um die in **Fig.6D** gezeigte Schichtenfolge 630 zu erhalten, wird in situ dotiertes polykristallines Silizium-Material auf der Schichtenfolge 620 abgeschieden und unter Verwendung einer TEOS-Hartmaske und eines Photolacks mittels eines Lithographie- und eines Ätz-Verfahrens derart strukturiert, dass dadurch ein Steuer-Gate-Bereich 631 auf den mit thermischem Siliziumoxid-Material bedeckten Silizium-Finnen 611 und auf freiliegenden Oberflächenbereichen der Siliziumoxid-Schicht 603 gebildet wird. Nachfolgend wird eine ONO-Schichtenfolge 632 ganzflächig ausgebildet. Hierfür wird zunächst die mit dem polykristallinen Silizium-Material bedeckte Schichtenfolge einem thermischen Oxidierungs-Verfahren unterzogen, wodurch eine erste Siliziumoxid-Schicht der ONO-Schichtenfolge 632 aus Material des Steuer-Gate-Bereichs 631 aus polykristallinem Silizium gebildet wird. Die erste Siliziumoxid-Schicht der ONO-Schichtenfolge 632 weist eine Dicke von 5nm auf. Nachfolgend wird Siliziumnitrid-Material mit einer Dicke von 5nm auf der so erhaltenen Schichtenfolge abgeschieden, um eine Siliziumnitrid-Schicht als Trapping Layer der ONO-Schichtenfolge 632 auszubilden. In einem Hochtemperaturverfahren wird nachfolgend eine zweite Siliziumoxid-Schicht der ONO-Schichtenfolge 632 mit einer Dicke von 5nm abgeschieden.

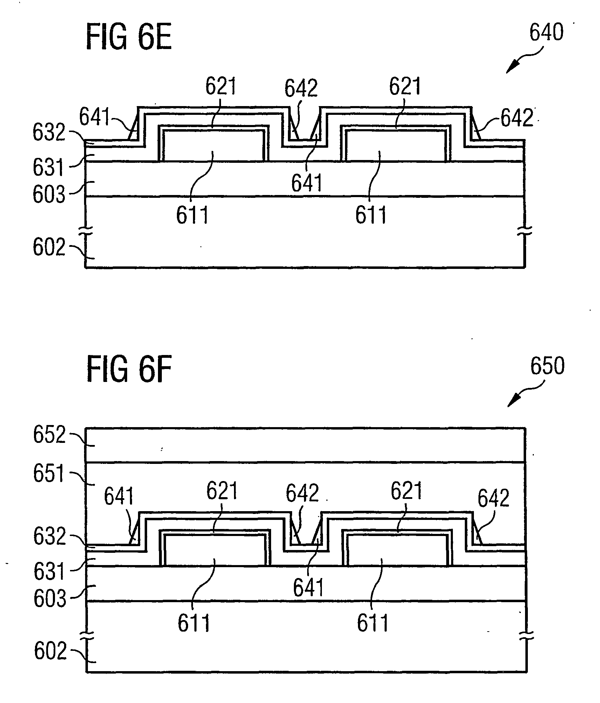

Um die in **Fig.6E** gezeigte Schichtenfolge 640 zu erhalten, wird zunächst in situ dotiertes polykristallines Silizium-Material auf der Schichtenfolge 630 abgeschieden. Nachfolgend wird eine Spacer-Ätzung zum Ausbilden erster und zweiter Wortleitungen 641, 642 durchgeführt. Die Spacer-Ätzung wird derart durchgeführt, dass die Wortleitungen 641, 642 etwas tiefer liegend angeordnet sind, so dass eine nachfolgend durchzuführende Kontaktloch-Ätzung unkritischer ist. Die Silizium-Finne 611 sollte in gemäß Fig.6E vertikaler Richtung etwas höher sein als der Steuer-Gate-Bereich 631 auf der Silizium-Finne 611, so dass der Spacer an dem Steuer-Gate-Bereich 631 entfernt wird und sich die Wortleitungen 641, 642 dennoch ausbilden.

Um die in **Fig.6F** gezeigte Speicherzelle 650 zu erhalten, wird zunächst eine zusätzliche Siliziumnitrid-Schicht 651 ganzflächig abgeschieden, und zum Ausbilden einer Implantationsmaske für Bitleitungen eine Spacer-Ätzung durchgeführt. Nachfolgend werden die Bitleitungen implantiert (nicht gezeigt). Die so erhaltene Schichtenfolge wird mit einer zusätzlichen Siliziumoxid-Schicht 652 bedeckt. Nachfolgend wird ein versetztes Kontaktlochätzen im Bereich der Bitleitungen, des Steuer-Gates 631 und der Wortleitungen 641, 642 durchgeführt.

In diesem Dokument sind folgende Veröffentlichungen zitiert:
[1] Eitan, B, Pavan, P, Bloom, I, Aloni, E, Frommer, A, Finzi, D (2000) "NROM: A Novel Localized Trapping, 2-Bit Nonvolatile Memory Cell" IEEE Electron Device Letters 21(11):543-545
[2] Tomiye, H, Terano, T, Nomoto, K, Kobayashi, T (2002) "A novel 2-bit/cell MONOS memory device with a wrapped-control-gate structure that applies source-side hot-electron injection" VLSI 2002 Symposium , S.206-207

### Bezugszeichenliste

- 100: Speicherzelle
- 101: Silizium-Substrat
- 102: erste Bitleitung
- 103: zweite Bitleitung
- 104: Gate-Dielektrikum
- 105: Steuer-Gate
- 106: ONO-Schichtenfolge
- 107: Wortleitung
- 108: erster Ladungsspeicherbereich
- 109: zweiter Ladungsspeicherbereich
- 110: Kanal-Bereich
- 200: Fin-Feldeffekttransistor-Speicherzelle
- 201: erster Source-/Drain-Bereich
- 202: zweiter Source-/Drain-Bereich
- 203: Steuer-Gate
- 204: Silizium-Finne
- 205: erste Wortleitung
- 206: zweite Wortleitung
- 207: erster ONO-Bereich
- 208: zweiter ONO-Bereich
- 209: erster Ladungsspeicherbereich
- 210: zweiter Ladungsspeicherbereich
- 211: dritter Ladungsspeicherbereich
- 212: vierter Ladungsspeicherbereich
- 300: Fin-Feldeffekttransistor-Speicherzellen-Anordnung
- 301: zweite Fin-Feldeffekttransistor-Speicherzelle
- 302: dritte Fin-Feldeffekttransistor-Speicherzelle
- 303: vierte Fin-Feldeffekttransistor-Speicherzelle
- 304: Steuer-Gate-Leitung
- 305: erste Bitleitung
- 306: zweite Bitleitung
- 400: erste Querschnittansicht
- 401: Silizium-Substrat
- 402: Siliziumoxid-Schicht
- 403: Kanal-Bereich
- 404: Siliziumnitrid-Schicht
- 500: zweite Querschnittansicht
- 600: Schichtenfolge
- 601: SOI-Wafer
- 602: erste Silizium-Schicht
- 603: Siliziumoxid-Schicht
- 604: zweite Silizium-Schicht
- 605: TEOS-Hartmaske
- 606: Photoresist
- 610: Schichtenfolge
- 611: Silizium-Finne
- 620: Schichtenfolge
- 621: Gate-isolierende Schicht
- 630: Schichtenfolge
- 631: Steuer-Gate-Bereich
- 632: ONO-Schichtenfolge
- 640: Schichtenfolge
- 641: erste Wortleitungen
- 642: zweite Wortleitungen
- 650: Speicherzelle
- 651: zusätzliche Siliziumnitrid-Schicht
- 652: zusätzliche Siliziumoxid-Schicht

## Patentansprüche

1. Fin-Feldeffekttransistor-Speicherzelle (200)
• mit einem ersten (201) und einem zweiten (202) Source-/Drain-Bereich;
• mit einem Gate-Bereich (204);
• mit einer den Kanal-Bereich aufweisenden Halbleiter-Finne zwischen dem ersten (201) und dem zweiten (202) Source-/Drain-Bereich;
• mit einer als Trapping-Schicht ausgestalteten Ladungsspeicherschicht (207, 208);
• mit einem Wortleitungs-Bereich (205, 206) auf zumindest einem Teil der Ladungsspeicherschicht (207, 208);
• wobei die Ladungsspeicherschich (207, 208) derart eingerichtet ist, dass mittels Anlegens vorgebbarer elektrischer Potentiale an die Fin-Feldeffekttransistor-Speicherzelle (200) in die Ladungsspeicherschicht elektrische Ladungsträger selektiv einbringbar oder daraus-entfernbar sind; **dadurch gekennzeichnet daß** die Ladungspeicherschicht zumindest teilweise auf dem Gate-Bereich angeordnet ist.

2. Speicherzelle nach Anspruch 1,
bei welcher der Wortleitungsbereich in einen ersten Wortleitungsteilbereich und in einen zweiten Wortleitungsteilbereich derart aufgeteilt ist, dass in einen Grenzbereich des ersten Wortleitungsteilbereichs mit der Ladungsspeicherschicht und in einen Grenzbereich des zweiten Wortleitungsteilbereich mit der Ladungsspeicherschicht jeweils elektrische Ladungsträger einbringbar sind oder daraus entfernbar sind.

3. Speicherzelle nach Anspruch 2,
bei der die ersten und zweiten Wortleitungsteilbereiche an zwei gegenüberliegenden seitlichen Abschnitten des Gate-Bereichs angeordnet sind.

4. Speicherzelle nach einem der Ansprüche 1 bis 3,
bei der die Ladungsspeicherschicht
• eine Siliziumoxid-Siliziumnitrid-Siliziumoxid-Schichtenfolge;
• Aluminiumoxid;
• Yttriumoxid;
• Lanthanoxid;
• Hafniumoxid;
• amorphes Silizium;
• Tantaloxid;
• Titanoxid;
• Zirkoniumoxid; und/oder
• ein Aluminat
aufweist oder daraus besteht.

5. Speicherzelle nach einem der Ansprüche 1 bis 4,
bei welcher der Gate-Bereich die Halbleiter-Finne im Wesentlichen U-förmig umgibt.

6. Speicherzelle nach einem der Ansprüche 1 bis 5,
bei der die Höhe der Halbleiter-Finne derart gewählt ist, dass ein vorgebbarer Wert für einen Lesestrom zum Auslesen von in der Speicherzelle gespeicherter Information erreicht ist.

7. Speicherzelle nach einem der Ansprüche 1 bis 6,
die einen mit dem ersten Source-/Drain-Bereich gekoppelten ersten Bitleitungsbereich und einen mit dem zweiten Source-/Drain-Bereich gekoppelten zweiten Bitleitungsbereich aufweist.

8. Speicherzelle nach Anspruch 7,
die derart eingerichtet ist, dass mittels Anlegens vorgebbarer elektrischer Potentiale an den Gate-Bereich, an den Wortleitungsbereich und an zumindest einen Bitleitungsbereich Ladungsträger in die Ladungsspeicherschicht mittels Injizierens heißer Ladungsträger selektiv einbringbar oder daraus entfernbar sind.

9. Fin-Feldeffekttransistor-Speicherzellen-Anordnung,
mit einer.Mehrzahl von Fin-Feldeffekttransistor-Speicherzellen nach einem der Ansprüche 1 bis 8.

10. Speicherzellen-Anordnung nach Anspruch 9,
bei der die Fin-Feldeffekttransistor-Speicherzellen im Wesentlichen matrixförmig angeordnet sind.

11. Speicherzellen-Anordnung nach Anspruch 9 oder 10,
bei der entlang einer ersten Richtung angeordnete Speicherzellen gemeinsame Wortleitungsbereiche aufweisen.

12. Speicherzellen-Anordnung nach einem der Ansprüche 9 bis 11,
bei der entlang einer zweiten Richtung angeordnete Speicherzellen gemeinsame Bitleitungsbereiche aufweisen.

13. Speicherzellen-Anordnung nach Anspruch 12,
bei der die erste und die zweite Richtung zueinander im Wesentlichen orthogonal verlaufende Richtungen sind.

14. Speicherzellen-Anordnung nach einem der Ansprüche 9 bis 13,
bei der die laterale Ausdehnung eines Wortleitungsbereichs in einem Abschnitt, in dem er einen Gate-Bereich kreuzt, kleiner ist als in einem von einer Kreuzung mit einem Gate-Bereich freien Abschnitt.

15. Verfahren zum Herstellen einer Fin-Feldeffekttransistor-Speicherzelle,
bei dem
• ein erster (201) und ein zweiter (202) Source-/Drain-Bereich gebildet werden;
• ein Gate-Bereich (204) gebildet wird;
• eine einen Kanal-Bereich aufweisende Halbleiter-Finne zwischen dem ersten (201) und dem zweiten (202) Source-/Drain-Bereich gebildet wird;
• eine als Trapping-Schicht ausgestaltete Ladungsspeicherschict (207, 208) gebildet wird, die zumindest teilweise auf dem Gate-Bereich (204) angeordnet wird;
• ein Wortleitungs-Bereich auf zumindest einem Teil der Ladungsspeicherschicht gebildet wird;
• die Ladungsspeicherschicht derart eingerichtet wird, dass mittels Anlegens vorgebbarer elektrischer Potentiale an die Fin-Feldeffekttransistor-Speicherzelle in die Ladungsspeicherschicht elektrische Ladungsträger selektiv einbringbar oder daraus entfernbar sind.

## Claims

1. A fin field effect transistor memory cell (200)
• having a first (201) and a second (202) source/drain region;
• having a gate region (204);
• having a semiconductor fin having the channel region between the first (201) and the second (202) source/drain region;
• having a charge storage layer (207, 208) configured as a trapping layer;
• having a word line region (205, 206) on at least one part of the charge storage layer (207, 208);
• the charge storage layer (207, 208) being set up in such a way that electrical charge carriers can be selectively introduced into the charge storage layer or be removed therefrom by means of applying predeterminable electrical potentials to the fin field effect transistor memory cell (200); **characterized in that** the charge storage layer is arranged at least partly on the gate region.

2. The memory cell as claimed in claim 1,
in which the word line region is divided into a first word line partial region and into a second word line partial region in such a way that electrical charge carriers can in each case be introduced into a boundary region of the first word line partial region and the charge storage layer and into a boundary region of the second word line partial region and the charge storage layer or be removed therefrom.

3. The memory cell as claimed in claim 2,
in which the first and second word line partial regions are arranged at two opposite lateral sections of the gate region.

4. The memory cell as claimed in one of claims 1 to 3,
in which the charge storage layer has or comprises
• a silicon oxide/silicon nitride/silicon oxide layer sequence;
• aluminum oxide;
• yttrium oxide;
• lanthanum oxide;
• hafnium oxide;
• amorphous silicon;
• tantalum oxide;
• titanium oxide;
• zirconium oxide; and/or
• an aluminate.

5. The memory cell as claimed in one of claims 1 to 4,
in which the gate region surrounds the semiconductor fin in an essentially U-shaped manner.

6. The memory cell as claimed in one of claims 1 to 5,
in which the height of the semiconductor fin is chosen in such a way as to achieve a predeterminable value for a read current for reading out information stored in the memory cell.

7. The memory cell as claimed in one of claims 1 to 6,
which has a first bit line region coupled to the first source/drain region and a second bit line region coupled to the second source/drain region.

8. The memory cell as claimed in claim 7,
which is set up in such a way that, by means of applying predeterminable electrical potentials to the gate region, to the word line region and to at least one bit line region, charge carriers can selectively be introduced into the charge storage layer by means of injection of hot charge carriers or be removed therefrom.

9. A fin field effect transistor memory cell arrangement,
having a plurality of fin field effect transistor memory cells as claimed in one of claims 1 to 8.

10. The memory cell arrangement as claimed in claim 9,
in which the fin field effect transistor memory cells are arranged essentially in matrix-type fashion.

11. The memory cell arrangement as claimed in claim 9 or 10,
in which memory cells arranged along a first direction have common word line regions.

12. The memory cell arrangement as claimed in one of claims 9 to 11,
in which memory cells arranged along a second direction have common bit line regions.

13. The memory cell arrangement as claimed in claim 12,
in which the first and second directions are directions that essentially run orthogonally with respect to one another.

14. The memory cell arrangement as claimed in one of claims 9 to 13,
in which the lateral extent of a word line region is smaller in a section in which it crosses a gate region than in a section free of a crossing with a gate region.

15. A method for the production of a fin field effect transistor memory cell,
in which
• a first (201) and a second (202) source/drain region are formed;
• a gate region (204) is formed;
• a semiconductor fin having a channel region is formed between the first (201) and the second (202) source/drain region;
• a charge storage layer (207, 208) configured as a trapping layer is formed, which is arranged at least partly on the gate region (204);
• a word line region is formed on at least one part of the charge storage layer;
• the charge storage layer is set up in such a way that electrical charge carriers can be selectively introduced into the charge storage layer or be removed therefrom by means of applying predeterminable electrical potentials to the fin field effect transistor memory cell.

## Revendications

1. Cellule (200) de mémoire à transistor à effet de champ à aileron
• comprenant une première zone (201) et une deuxième zone (202) de source/drain ;
• comprenant une zone (204) de grille ;
• comprenant un aileron à semi-conducteur ayant la zone de canal entre la première zone (201) et la deuxième zone (202) de source/drain ;
• comprenant une couche (207, 208) d'accumulation de charge constituée en couche de trapping;
• comprenant une zone (205, 206) de ligne de mot sur au moins une partie de la zone (207, 208) d'accumulation de charge ;
• dans laquelle la couche (207, 208) d'accumulation de charge est telle qu'en appliquant des potentiels électriques qui peuvent être prescrits à la cellule (200) de mémoire à transistor à effet de champ à aileron, des porteurs de charge électriques peuvent être introduits sélectivement dans la couche d'accumulation de charge et en être enlevés ; **caractérisée en ce que** la couche d'accumulation de charge est disposée au moins en partie sur la zone de grille.

2. Cellule de mémoire selon la revendication 1,
dans laquelle la zone de ligne de mot est subdivisée en une première sous-zone de ligne de mot et en une deuxième sous-zone de ligne de mot, en ce que dans une zone limite de la première sous-zone de ligne de mot ayant la couche d'accumulation de charge et dans une zone limite de la deuxième sous-zone de ligne de mot ayant la couche d'accumulation de mémoire des porteurs de charge électriques peuvent être respectivement introduits ou en être enlevés.

3. Cellule de mémoire selon la revendication 2,
dans laquelle les première et deuxième sous-zones de ligne de mot sont disposées sur deux parties latérales opposées de la zone de grille.

4. Cellule de mémoire selon l'une des revendications 1 à 3,
dans laquelle la couche d'accumulation de charge a
• une succession de couches oxyde de silicium-nitrure de silicium-oxyde de silicium ;
• de l'oxyde d'aluminium ;
• de l'oxyde d'yttrium ;
• de l'oxyde de lanthane ;
• de l'oxyde d'hafnium ;
• du silicium amorphe ;
• de l'oxyde de tantale ;
• de l'oxyde de titane ;
• de l'oxyde de zirconium et/ou
• un aluminate
ou en est constituée.

5. Cellule de mémoire selon l'une des revendications 1 à 4,
dans laquelle la zone de grille entoure sensiblement en forme de U les ailerons à semi-conducteur.

6. Cellule de mémoire selon l'une des revendications 1 à 5,
dans laquelle la hauteur des ailerons à semi-conducteur est choisie de manière à obtenir une valeur pouvant être prescrite d'un courant de lecture pour lire de l'information mémorisée dans la cellule de mémoire.

7. Cellule de mémoire selon l'une des revendications 1 à 6,
qui a une première zone de ligne de bit couplée à la première zone de source/drain et une deuxième zone de ligne de bit couplée à la deuxième zone de source/drain.

8. Cellule de mémoire selon la revendication 7,
qui est telle qu'en appliquant des potentiels électriques pouvant être prescrits par la zone de grille à la zone de ligne de mot et à au moins une zone de ligne de bit, des porteurs de charge peuvent être introduits sélectivement dans la couche d'accumulation de charge au moyen d'une injection de porteurs de charge ou en être enlevés.

9. Dispositif de cellule de mémoire à transistor à effet de champ à aileron ayant une multiplicité de cellules de mémoire à transistor à effet de champ à aileron suivant l'une des revendications 1 à 8.

10. Dispositif de cellule de mémoire suivant la revendication 9,
dans lequel les cellules de mémoire à transistor à effet de champ à aileron sont disposées sensiblement sous la forme d'une matrice.

11. Dispositif de cellule de mémoire suivant la revendication 9 ou 10,
dans lequel des cellules de mémoire disposées le long d'une première direction ont des zones de ligne de mot communes.

12. Dispositif de cellule de mémoire suivant l'une des revendications 9 à 11,
dans lequel des cellules de mémoire disposées suivant une deuxième direction ont des zones de ligne de bit communes.

13. Dispositif de cellule de mémoire suivant la revendication 12,
dans lequel la première et la deuxième direction sont des directions sensiblement orthogonales entre elles.

14. Dispositif de cellule de mémoire suivant l'une des revendications 9 à 13,
dans lequel l'étendue latérale d'une zone de ligne de mot est dans une partie dans laquelle elle croise une zone de grille plus petite que dans une partie exempte d'un croisement avec une zone de grille.

15. Procédé de production d'une cellule de mémoire à transistor à effet de champ à aileron,
dans lequel
• on forme une première zone (201) et une deuxième zone (202) de source/drain ;
• on forme une zone (204) de grille;
• on forme un aileron à semi-conducteur ayant une zone de canal entre la première zone (201) et la deuxième zone (202) de source/drain ;
• on forme une couche (207, 208) d'accumulation de charge constituée en couche de trapping, qui est disposée au moins en partie sur la zone (204) de grille ;
• on forme une zone de ligne de mot sur au moins une partie de la couche d'accumulation de charge ;
• on agence la couche d'accumulation de charge de façon qu'en appliquant des potentiels électriques prescrits aux cellules de mémoire à transistor à effet de champ à aileron on peut introduire sélectivement des porteurs de charge électriques dans la couche d'accumulation de charge ou les en enlever.
